# FASCICULE DE BREVET EUROPEEN

(11) **EP 1 152 533 B1**
(45) Date de publication et mention de la délivrance du brevet: **02.07.2008**
(21) Numéro de dépôt: 01401098.7
(22) Date de dépôt: 26.04.2001
(51) Int. Cl.: H03K 17/94, H03K 17/95, H03K 17/955

(54) **Détecteur inductif ou capacitif**
Induktiver oder kapazitiver Detektor
Inductive or capacitive detector

(30) Priorité: 02.05.2000 FR 0005675
(43) Date de publication de la demande: 07.11.2001
(73) Titulaire: SCHNEIDER ELECTRIC INDUSTRIES SAS, 92500 Rueil-Malmaison (FR)
(72) Inventeur: Charneau, Christian, 16430 Champniers (FR); Guichard, Christophe, 16000 Angouleme (FR)

(56) Documents cités:
- EP-A- 0 203 923
- EP-A- 0 478 856
- EP-A- 0 996 228
- GB-A- 1 510 034
- PATENT ABSTRACTS OF JAPAN vol. 006, no. 077 (E-106), 14 mai 1982 (1982-05-14) & JP 57 014219 A (OMRON TATEISI ELECTRONICS CO), 25 janvier 1982 (1982-01-25)

## Description

La présente invention concerne un procédé de détection mis en oeuvre à l'aide d'un détecteur de proximité inductif ou capacitif, notamment apte à détecter des métaux ferreux et non ferreux et un détecteur de proximité capacitif ou inductif, comprenant un oscillateur apte à délivrer un signal de mesure dont la fréquence est fonction de la proximité d'un objet à détecter, et un circuit de traitement numérique qui commande une sortie du détecteur en fonction de la fréquence de l'oscillateur de mesure.

Un tel détecteur de proximité est connu d'après le document DE 32 04 405. Dans ce détecteur, il est prévu deux oscillateurs oscillant à la même fréquence, l'un des oscillateurs étant influençable, l'autre oscillateur n'étant pas influençable, par l'objet à détecter. Les sorties des oscillateurs sont appliquées à des compteurs respectifs de manière que la différence de comptage observée en présence d'une cible est exploitée par un circuit logique qui commute un signal de sortie.

D'autre part, le document GB 1 510 034 décrit un détecteur de proximité inductif comportant un oscillateur à fréquence variable et un oscillateur de référence opérant avec un compteur de détection et un compteur de référence, ce dernier définissant un intervalle de comptage pour le compteur de détection .

Les détecteurs de proximité connus ne permettent pas de tenir compte des variations ou dérives affectant les composants du circuit de traitement, notamment en fonction de la température, ce qui entraîne donc une précision et une fidélité de mesure insuffisantes.
Le document EP 0 478 856 décrit notamment un oscillateur dont la fréquence peut être réglée à partir d'un clavier.

L'invention a pour but de permettre de détecter des objets, particulièrement en métaux ferreux et/ou non ferreux, par un traitement de fréquence assurant une excellente précision de mesure.

Selon l'invention, la valeur de comptage de consigne est contenue dans une mémoire associée au circuit de traitement numérique et elle est corrigible notamment en fonction de la température, et une valeur de comptage d'étalonnage est introduite dans la mémoire lors d'un étalonnage du détecteur en présence d'un objet situé à la portée nominale, la valeur de comptage de consigne étant obtenue par correction de la valeur d'étalonnage en fonction de la température.

De préférence, la valeur de comptage de consigne est corrigée cycliquement, par exemple à chaque mesure, ou toutes les n mesures, n étant un nombre prédéterminé, en fonction de la température ambiante alors mesurée.

La description va être faite ci-après d'un mode de réalisation non limitatif de l'invention, en regard des dessins annexés.

La figure 1 représente un schéma du circuit d'un détecteur de proximité inductif conforme à l'invention.

La figue 2 montre schématiquement le boîtier d'un détecteur selon l'invention.

La figure 3 est un schéma synoptique du mode de fonctionnement du détecteur de la figure 1.

La figure 4 est un schéma synoptique représentant l'étalonnage du détecteur.

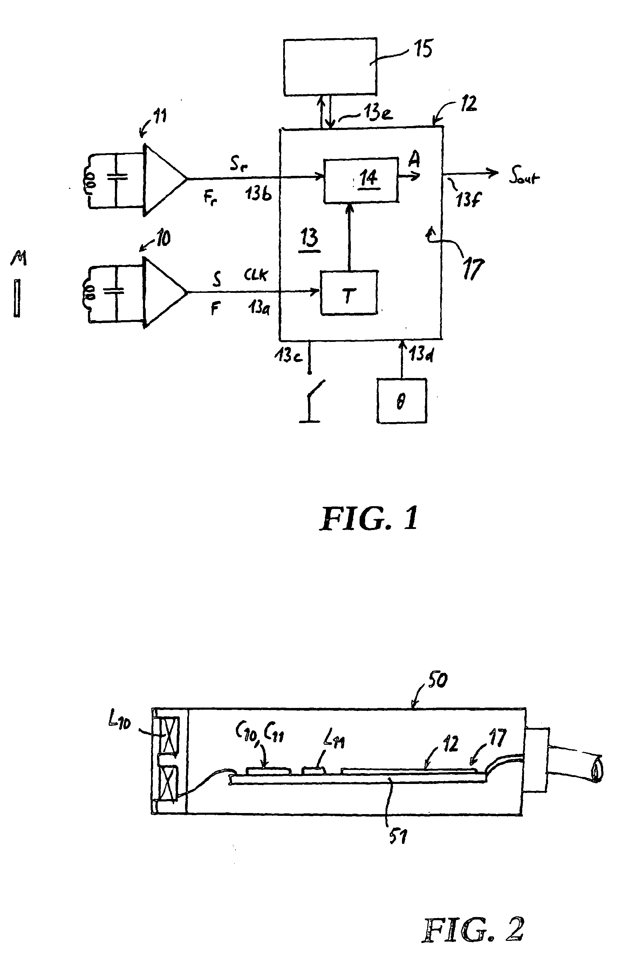

Le détecteur inductif illustré sur la figure 1 comprend un oscillateur de mesure 10 qui délivre une oscillation à un circuit de mise en forme de manière à produire un signal pulsé de mesure S dont la fréquence F dépend de la proximité d'un objet métallique M, de type ferreux ou non ferreux. Le détecteur est soit universel, c'est-à-dire capable de détecter indifféremment et à la même distance des objets ferreux et non ferreux, soit sélectif, c'est-à-dire capable de détecter uniquement les objets ferreux ou non ferreux.

Il est prévu dans le détecteur un oscillateur de référence 11 apte à délivrer après mise en forme un signal pulsé de référence Sᵣ dont la fréquence Fᵣ ne dépend pas de l'objet. L'oscillateur 10 oscille par exemple à une fréquence de mesure F de l'ordre de 1 MHz, variable à l'approche d'un objet métallique, et l'oscillateur 11 oscille par exemple à une fréquence fixe Fᵣ qui peut être selon les applications de l'ordre de quelques centaines de kHz ou de quelques MHz, et qui, dans le mode de réalisation considéré, est de 8 MHz. Les fréquences F et Fᵣ pourraient aussi être égales. Le détecteur comprend un circuit de traitement 12 doté d'un circuit logique programmé, microcontrôleur ou circuit similaire 13 à une entrée d'horloge 13a duquel est appliqué le signal de mesure S et à une entrée de comptage 13b duquel est appliqué le signal de référence Sᵣ. L'entrée de comptage 13b est relié à un compteur 14 du microcontrôleur 13. Le microcontrôleur présente une entrée d'étalonnage 13c et une entrée d'acquisition de température 13d. Une mémoire réinscriptible 15 par exemple de type EEPROM est reliée à une entrée/sortie 13e du microcontrôleur, tandis qu'une sortie 13f du microcontrôleur achemine un signal de commande Sₒᵤₜ de la sortie du détecteur.

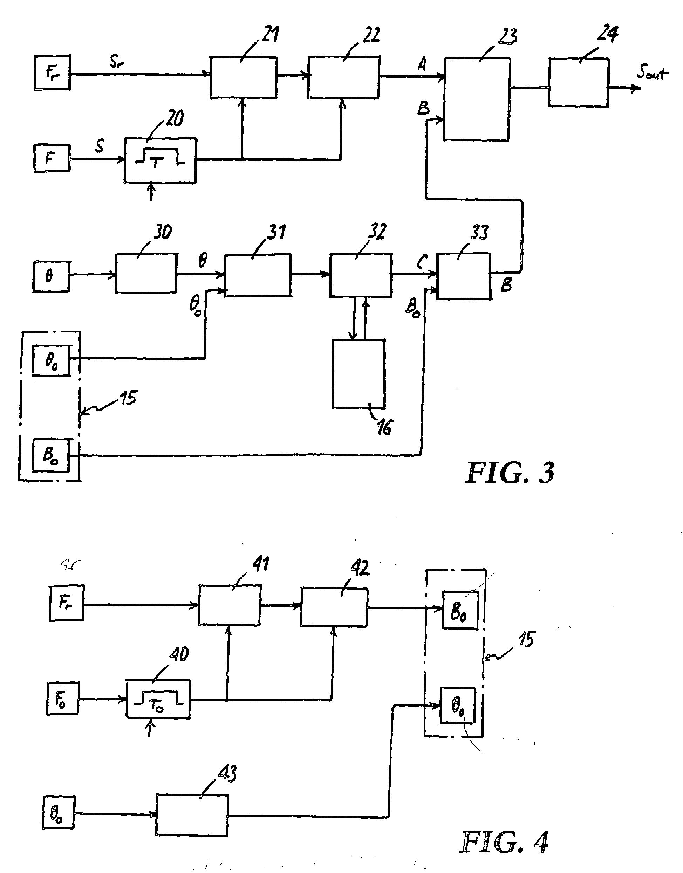

La figure 3 illustre le programme principal de fonctionnement du détecteur. Les impulsions de mesure S correspondant à la fréquence de mesure F sont comptées pour créer une fenêtre de comptage de largeur T, définie dans une opération 20 ; la largeur T de cette fenêtre est égale à un nombre donné (et constant) de périodes d'horloge du microcontrôleur et elle est inversement proportionnelle à la fréquence de S. La largeur T est égale à K/F, K étant une constante. Le compteur 14 reçoit de l'entrée 13b le signal de référence Sᵣ et effectue dans une étape 21 un comptage, dans la fenêtre T dépendant du signal de mesure S, du nombre d'impulsions (par exemple quelques milliers) du signal de référence Sᵣ. Il en résulte une valeur de comptage A qui est lue dans une étape 22. En variante, on peut aussi compter les impulsions du signal de mesure S dans une fenêtre fixe fonction de la fréquence de référence Fᵣ.

Une comparaison de cette valeur de comptage A est effectuée dans une étape 23 avec une valeur de consigne corrigible B dont l'élaboration va maintenant être décrite et qui est mise à jour cycliquement, par exemple en étant modifiée toutes les mesures ou, pour économiser le temps de traitement, toutes les n mesures, n pouvant être égal à 3. En fonction de la comparaison est émis un signal de commande de sortie (opération 24).

La température du détecteur est acquise dans une étape 30 de définition d'une valeur numérique θ à partir d'un élément détecteur de température analogique ; cette valeur est comparée dans une étape 31 avec une valeur θ₀ définie lors d'une phase d'étalonnage qui sera décrite plus loin. Il en résulte un écart calculé E = θ - θ₀. La valeur B₀ est aussi établie au cours de la phase d'étalonnage. Dans une étape ultérieure 32 d'établissement d'une valeur de correction C, le microcontrôleur recherche dans une table de correction 16 la valeur C correspondant à l'écart E qui a été calculé. Dans une étape ultérieure 33, le microcontrôleur calcule la somme B = B₀ + C et cette valeur B est utilisée dans l'étape 23 comme décrit plus haut..

Le logiciel permettant d'acquérir le couple de valeurs B₀, θ₀ dans la phase d'étalonnage va maintenant être décrit en regard de la figure 4.

Une cible est positionnée à la distance de détection souhaitée (portée) du détecteur, puis un ordre de déclenchement d'étalonnage est formulé par l'opérateur, de préférence par mise à la masse de l'entrée 13c du microcontrôleur.

Le déclenchement de l'étalonnage démarre une opération 40 de définition de la fenêtre de mesure T₀ = K/F_{0,} K étant une constante et F₀ étant la fréquence de l'oscillateur de mesure à la portée. Le compteur démarre un comptage 41 des impulsions du signal de référence Sᵣ provenant de l'oscillateur de référence 11 après mise en forme. La valeur de comptage B₀ obtenue à la fin de la fenêtre de mesure T₀ est lue dans une opération 42 et mémorisée dans la mémoire EEPROM 15.

L'étalonnage se poursuit par une opération 43 de mesure de la température et la valeur analogique correspondante est convertie en une valeur numérique θ₀ qui est également mémorisée dans la mémoire EEPROM 16. Le couple B₀, θ ₀ est ensuite pris en considération dans les mesures courantes comme on l'a vu plus haut. L'étalonnage décrit permet de s'affranchir des dispersions et variations affectant les composants du circuit. L'hystérésis de commutation du détecteur est introduite dans le logiciel de conduite de la mesure en tant que correction de la valeur de comptage de consigne B. L'étalonnage est effectué initialement et à tout moment jugé utile.

Un exemple de réalisation compacte du détecteur est illustré schématiquement sur la figure 2. Le boîtier 50 du détecteur loge les deux oscillateurs 10,11 qui présentent des circuits oscillants LC. L'inductance L₁₀ de l'oscillateur 10 est une inductance à air avec ou sans noyau de ferrite. L'inductance L₁₁ de l'oscillateur 11 est située sur le circuit imprimé 51 qui présente le circuit de traitement 12 et le circuit de sortie 17. Les capacités C₁₀,C₁₁ des deux oscillateurs font partie d'un même réseau capacitif situé sur le circuit imprimé 51 de manière à présenter des dérives en température aussi proches que possible.

Le détecteur décrit est de type universel détectant à la même distance des objets ferreux et non ferreux. Il peut aussi être de type sélectif, et la fréquence Fᵣ est alors beaucoup plus basse, par exemple de l'ordre de quelques dizaines de kHz. L'invention s'applique aussi aux détecteurs capacitifs.

## Revendications

1. Procédé de détection mis en oeuvre à l'aide d'un détecteur de proximité inductif ou capacitif, le détecteur comprenant :
- un oscillateur de mesure (10) apte à délivrer un signal pulsé (S) dont la fréquence (F) est fonction de la proximité d'un objet à détecter,
- un oscillateur de référence (11) apte à délivrer un signal pulsé (Sr) dont la fréquence (Fr) est indépendante de l'objet à détecter,
- un circuit de traitement numérique (12) qui délivre un signal de sortie du détecteur en fonction du signal fourni par l'oscillateur de mesure et auquel sont associés un compteur (14) et une valeur de comptage de consigne (B),
Procédé dans lequel :
- le compteur (14) délivre une valeur de comptage de détection (A) fonction du nombre d'impulsions reçues de l'un des oscillateurs (11,10) mesuré dans une fenêtre temporelle de comptage (T) dépendant de la fréquence (F) de l'autre oscillateur (10,11),
- la valeur de comptage de détection (A) est comparée à la valeur de comptage de consigne (B) pour engendrer le signal de sortie,
- la valeur de comptage de consigne (B) est contenue dans une mémoire (15) associée au circuit de traitement numérique (12),
- une valeur de comptage d'étalonnage (B₀) est introduite dans la mémoire lors d'un étalonnage du détecteur réalisé en présence d'un objet situé à la portée nominale,
ledit procédé étant **caractérisé en ce que**:
- la valeur de comptage de consigne (B) est obtenue par correction de la valeur de comptage d'étalonnage (B₀) en fonction de la température (θ).

2. Procédé selon la revendication 1, **caractérisé en ce que** la valeur de comptage de consigne (B) est modifiée cycliquement au terme d'un nombre prédéterminé de mesures.

3. Procédé selon la revendication 1, **caractérisé en ce que** la fenêtre temporelle de comptage (T) est fonction de la fréquence de l'oscillateur de mesure (10) et **en ce que** le circuit de traitement numérique (12) présente une entrée de comptage reliée à l'oscillateur de référence (11).

4. Procédé selon la revendication 1, **caractérisé en ce que** :
- au cours de l'étalonnage du détecteur sont mémorisées la valeur de comptage d'étalonnage (B₀) et une valeur de température de référence (θ₀),
- au cours d'une détection d'objet est mesurée une valeur de température courante (θ), une quantité de correction (C) de comptage étant déterminée dans une table de correction en fonction de l'écart (θ - θ₀) calculé par le circuit de traitement (12) entre la valeur de température courante et la valeur de température de référence,
- la valeur de comptage d'étalonnage (B₀) est affectée de la quantité de correction (C) pour engendrer la valeur de comptage de consigne corrigée (B).

5. Procédé selon la revendication 1, **caractérisé en ce que** l'étalonnage du détecteur est réalisé dans une opération d'apprentissage.

6. Procédé selon la revendication 1, **caractérisé en ce qu'**au début de l'étalonnage du détecteur est créée une fenêtre (T₀) de comptage d'impulsions inversement proportionnelle à la fréquence (F₀) de l'oscillateur de mesure (10).

7. Procédé selon la revendication 1, **caractérisé en ce que** le détecteur employé est de type inductif et tel que l'oscillateur de mesure (10) et l'oscillateur de référence (11) sont des oscillateurs à circuit oscillant LC dont les capacités (C₁₀, C₁₁) font partie d'un même réseau capacitif.

8. Procédé selon la revendication 1, **caractérisé en ce que** le circuit de traitement numérique (12) et le circuit de sortie sont implantés sur un circuit imprimé et **en ce que** l'inductance (L₁₁) de l'oscillateur de référence (11) est disposée sur le circuit imprimé, tandis que l'inductance (L₁₀) de l'oscillateur de mesure (10) est une inductance à air ou à ferrite.

9. Détecteur de proximité inductif ou capacitif, **caractérisé en ce qu'**il est apte à mettre en oeuvre le procédé de détection défini dans l'une des revendications 1 à 8.

## Claims

1. Detection method implemented with the help of an inductive or capacitive proximity detector, the detector comprising:
- a measurement oscillator (10) able to deliver a pulsed signal (S), the frequency (F) of which depends on the proximity of an object to be detected;
- a reference oscillator (11) able to deliver a pulsed signal (Sᵣ), the frequency (Fᵣ) of which is independent of the object to be detected; and
- a digital processing circuit (12) that delivers an output signal of the detector depending on the signal provided by the measurement oscillator and with which a counter (14) and a set count value (B) are associated,
in which method:
- the counter (14) delivers a detection count value (A) depending on the number of pulses received from one of the oscillators (11, 10) measured in a counting time window (T) depending on the frequency (F) of the other oscillator (10, 11);
- the detection count value (A) is compared with the set count value (B) to generate the output signal;
- the set count value (B) is contained in a memory (15) associated with the digital processing circuit (12); and
- a calibration count value (B₀) is input into the memory during a calibration of the detector carried out in the presence of an object situated at the nominal range;
said method being **characterized in that**:
- the set count value (B) is obtained by correcting the calibration count value (B₀) as a function of the temperature (θ).

2. Method according to Claim 1, **characterized in that** the set count value (B) is periodically modified at the end of a predetermined number of measurements.

3. Method according to Claim 1, **characterized in that** the counting time window (T) is a function of the frequency of the measurement oscillator (10) and **in that** the digital processing circuit (12) has a count input connected to the reference oscillator (11).

4. Method according to Claim 1, **characterized in that**:
- the calibration count value (B₀) and a reference temperature value (θ₀) are stored in the course of the calibration of the detector;
- a current temperature value (θ) is measured in the course of detecting an object, a correction count quantity (C) being determined in a correction table as a function of the difference (θ-θ₀) calculated by the processing circuit (12) between the current temperature value and the reference temperature value; and
- the calibration count value (B₀) is modified by the correction quantity (C) to generate the corrected set count value (B).

5. Method according to Claim 1, **characterized in that** the calibration of the detector is carried out in a learning operation.

6. Method according to Claim 1, **characterized in that** a pulse counting window (T₀) inversely proportional to the frequency (F₀) of the measurement oscillator (10) is created at the start of the calibration of the detector.

7. Method according to Claim 1, **characterized in that** the detector employed is inductive and such that the measurement oscillator (10) and the reference oscillator (11) are oscilllators of LC oscillating circuit type, the capacitors (C₁₀, C₁₁) of which are part of the same capacitive network.

8. Method according to Claim 1, **characterized in that** the digital processing circuit (12) and the output circuit are embedded in a printed circuit and **in that** the inductor (L₁₁) of the reference oscillator (11) is arranged on the printed circuit, while the inductor (L₁₀) of the measurement oscillator (10) is an air or ferrite inductor.

9. Inductive or capacitive proximity detector, **characterized in that** it is designed to implement the detection method defined in one of the claims 1 to 8.

## Patentansprüche

1. Erfassungsverfahren, das mit Hilfe eines induktiven oder kapazitiven Näherungsschalters angewendet wird, wobei der Sensor aufweist:
- einen Messoszillator (10), der fähig ist, ein gepulstes Signal (S) zu liefern, dessen Frequenz (F) von der Nähe eines zu erfassenden Gegenstands abhängt,
- einen Bezugsoszillator (11), der fähig ist, ein gepulstes Signal (Sr) zu liefern, dessen Frequenz (Fr) vom zu erfassenden Gegenstand unabhängig ist,
- eine digitale Verarbeitungsschaltung (12), die ein Ausgangssignal des Sensors in Abhängigkeit von dem Signal liefert, das vom Messoszillator geliefert wird, und der ein Zähler (14) und ein Zählsollwert (B) zugeordnet sind,
Verfahren, bei dem:
- der Zähler (14) einen Erfassungszählwert (A) liefert, der von der Anzahl von von einem der Oszillatoren (11, 10) empfangenen Impulsen abhängt, gemessen in einem 2ähl-2eitfenster (T), das von der Frequenz (F) des anderen Oszillators (10, 11) abhängt,
- der Erfassungszählwert (A) mit dem Sollzählwert (B) verglichen wird, um das Ausgangssignal zu erzeugen,
- der Sollzählwert (B) in einem Speicher (15) enthalten ist, der der digitalen Verarbeitungsschaltung (12) zugeordnet ist,
- bei einer Kalibrierung des Sensors, die in Gegenwart eines sich in Nennreichweite befindenden Gegenstands durchgeführt wird, ein Kalibrierungszählwert (B₀) in den Speicher eingegeben wird,
wobei das Verfahren **dadurch gekennzeichnet ist, dass**:
- der Sollzählwert (B) durch Korrektur des Kalibrierungszählwerts (B₀) in Abhängigkeit von der Temperatur (θ) erhalten wird.

2. Verfahren nach Anspruch 1, **dadurch gekennzeichnet, dass** der Sollzählwert (B) am Ende einer vorbestimmten Anzahl von Messungen zyklisch verändert wird.

3. Verfahren nach Anspruch 1, **dadurch gekennzeichnet, dass** das Zähl-Zeitfenster (T) von der Frequenz des Messoszillators (10) abhängt, und dass die digitale Verarbeitungsschaltung (12) einen Zähleingang aufweist, der mit dem Bezugsoszillator (11) verbunden ist.

4. Verfahren nach Anspruch 1, **dadurch gekennzeichnet, dass**:
- während der Kalibrierung des Sensors der Kalibrierungszählwert (B₀) und ein Bezugstemperaturwert (θ₀) gespeichert werden,
- während einer Gegenstanderfassung ein laufender Temperaturwert (θ) gemessen wird, wobei eine Zähl-Korrekturmenge (C) in einer Korrekturtabelle in Abhängigkeit von der Abweichung (θ-θ₀) bestimmt wird, die von der Verarbeitungsschaltung (12) zwischen dem laufenden Temperaturwert und dem Bezugstemperaturwert berechnet wird,
- dem Kalibrierungszählwert (B₀) die Korrekturmenge (C) zugeteilt wird, um den korrigierten Sollzählwert (B) zu erzeugen.

5. Verfahren nach Anspruch 1, **dadurch gekennzeichnet, dass** die Kalibrierung des Sensors in einem Lernvorgang durchgeführt wird.

6. Verfahren nach Anspruch 1, **dadurch gekennzeichnet, dass** zu Beginn der Kalibrierung des Sensors ein Fenster (T₀) zum Zählen von Impulsen umgekehrt proportional zur Frequenz (F₀) des Messoszillators (10) erzeugt wird.

7. Verfahren nach Anspruch 1, **dadurch gekennzeichnet, dass** der verwendete Sensor vom induktiven Typ und derart ist, dass der Messoszillator (10) und der Bezugsoszillator (11) Oszillatoren mit Schwingkreis LC sind, deren Kondensatoren (C₁₀, C₁₁) Teil des gleichen kapazitiven Netzwerks sind.

8. Verfahren nach Anspruch 1, **dadurch gekennzeichnet, dass** die digitale Verarbeitungsschaltung (12) und die Ausgangsschaltung in einer gedruckten Schaltung angeordnet sind, und dass die Induktivität (L₁₁) des Bezugsoszillators (11) auf der gedruckten Schaltung angeordnet ist, während die Induktivität (L₁₀) des Messoszillators (10) eine Luft- oder Ferrit-Induktivität ist.

9. Induktiver oder kapazitiver Näherungsschalter, **dadurch gekennzeichnet, dass** er geeignet ist, um das Erfassungsverfahren anzuwenden, das in einem der Ansprüche 1 bis 8 definiert ist.
